Europäisches Patentamt

European Patent Office

Office européen des brevets

(11) Veröffentlichungsnummer: **0 157 936**
**A1**

## (12) EUROPÄISCHE PATENTANMELDUNG

(21) Anmeldenummer: 84115567.4

(22) Anmeldetag: 17.12.84

(51) Int. Cl.⁴: **C 08 L 63/00**
//H01L23/08, H01J1/88,
H01H29/02, (C08L63/00,
C08K3:38)

(30) Priorität 28.03.84 DE 3411473

(43) Veröffentlichungstag der Anmeldung·
16.10.85 Patentblatt 85/42

(84) Benannte Vertragsstaaten:
AT DE NL

(71) Anmelder Siemens Aktiengesellschaft
Berlin und München Wittelsbacherplatz 2
D-8000 München 2(DE)

(72) Erfinder: Demmel, Franz
Kemptener Strasse 42
D-8500 Nürnberg(DE)

(72) Erfinder: Grimmer, Rudolf, Dr.
Reinschartenweg 17a
D-8520 Erlangen(DE)

(54) Form- und Überzugsmassen.

(57) Form- und Überzugsmassen auf der Basis von Epoxidharzen, die als Preßmassen, Transferpreßmassen, Tränk-und Gießharze eingesetzt werden können, enthalten neben üblichen Härtern, Füllstoffen, Hilfs- und Zusatzstoffen 10 bis 50 Gew.-% Bornitrid, bezogen auf die Gesamtmasse. Die ausgehärteten Isolierstoffe, die eine erhöhte Wärmeleitfähigkeit und einen niedrigeren Längenausdehnungskoeffizienten aufweisen, werden insbesondere für thermisch hochbelastete Isolierteile eingesetzt.

EP 0 157 936 A1

Siemens Aktiengesellschaft
Berlin und München

Unser Zeichen
VPA 84 P 3 1 1 3 E

Form- und Überzugsmassen

Die Erfindung betrifft Form- und Überzugsmassen mit hoher Wärmeleitfähigkeit, guten mechanischen Eigenschaften und guter Verarbeitbarkeit.

Vielfach reicht die Wärmeleitfähigkeit von gefüllten Preßmassen, Transferpreßmassen, Tränk- und Gießharzen nicht aus, um die Wärme von umhüllten elektrischen und elektronischen Bauteilen, Baugruppen und Geräten schnell und ausreichend abzuleiten. Die entsprechenden Werte bewegen sich zwischen 0,5 und 1,1 W/mK.

Durch vielfältige Maßnahmen hat man versucht die Wärmeleitfähigkeit von Harzen und daraus hergestellten Formteilen zu erhöhen. In Wärmeableitblechen bzw. Metallstücken wurden geeignete Hilfsmittel gesehen oder auch in einer Kühlung durch Luftstrom. Andererseits hat man versucht, durch Beimischen von Metallpulver die Wärmeleitfähigkeit zu erhöhen. Hierbei sind unter anderem aber eine höhere Dichte und der Verlust der Isoliereigenschaften in Kauf zu nehmen.

Der Erfindung liegt nun die Aufgabe zugrunde, die Wärmeleitfähigkeit von Form- und Überzugsmassen wirkungsvoll zu erhöhen, ohne daß die beschriebenen Nachteile auftreten.

Td 2 Gr / 20.03.1984

Die Aufgabe wird dadurch gelöst, daß die Form- und Überzugsmassen neben üblichen Füllstoffen 10 bis 50 Gew.-% Bornitrid, bezogen auf die Gesamtmasse, enthalten. Es hat sich gezeigt, daß es vorteilhaft ist, wenn der Anteil an Bornitrid 20 Gew.-% beträgt.

Überraschenderweise zeigt sich, daß mit Bornitridzusatz gefüllte Isolierstoffe aus Reaktionsharzsystemen, seien es nun Preßmassen, Transferpreßmassen, Tränk- oder Gießharze, eine um den Faktor 1,5 bis 4 erhöhte Wärmeleitfähigkeit aufweisen. Vielfach kann man Isolierteile infolge der verbesserten Wärmeableitung kostengünstiger konstruieren, was die Wirtschaftlichkeit erhöht. Andererseits ist es möglich, Bauelemente gleicher Geometrie mit größerer Leistung zu betreiben. Ganz wesentliche zusätzliche günstige Effekte sind schließlich der geringere Formenabrieb und die geringere Längenausdehnung $\alpha$, die damit näher an der der isolierten Metallbauteile liegt. Die mechanischen und elektrischen Eigenschaften und die Isoliereigenschaften erleiden kaum Einbuße.

Geeignet sind aromatische und cycloaliphatische Epoxidharze, insbesondere solche auf Basis von Bisphenol A, Novolak-Epoxidharz, Glycidylester sowie cycloaliphatische ringepoxidierte Verbindungen.

Zur Durchhärtung der Form- und Überzugsmassen werden Anhydride, aromatische Amine, Phenole und katalytische Härter, gegebenenfalls unter Zugabe von Beschleunigern, eingesetzt.

Geeignete Füllstoffe sind Quarzmehl, Quarzgutmehl, Siliziumcarbid, Kreide, Dolomitmehl.

Das erfindungsgemäß eingesetzte Bornitrid wird vorzugsweise als feinkörniges Pulver bis zu 200 μm eingesetzt.

Die erfindungsgemäßen Massen werden vor allem zur Herstellung von thermisch hochbelastbaren Isolierteilen verwendet, beispielsweise für Ringe für Kathodenfallableiter und als Umhüllmasse für elektrische und elektronische Bauelemente.

Die Erfindung wird anhand der Beispiele näher erläutert.

Beispiel 1

Eine Mischung aus 100 Gew.-Teilen des Bisphenolepoxidharzes mit einer Epoxidzahl von 0,54, 80 Gew.-Teilen Hexahydrophthalsäureanhydrid, 15 Gew.-Teilen Polypropylenglykol, 0,5 Gew.-Teilen Dimethylbenzylamin, 251 Gew.-Teilen Quarzmehl und 112 Gew.-Teilen Bornitrid wird bei 80 °C im Vakuum gemischt und in auf 80 °C vorgewärmte Stahlformen gegossen. Die Aushärtung erfolgt 4 Std. bei 80 °C und anschließend 4 Std. bei 120 °C.

Die erhaltenen Formstoffe haben eine Wärmeleitfähigkeit von 1,35 W/mK und einen Längenausdehnungskoeffizienten von $31,2 \times 10^{-6} K^{-1}$.

Beispiel 2

Eine Mischung aus 100 Gew.-Teilen Hexahydrophthalsäurediglycidylester (Epoxidzahl 0,57), 90 Gew.-Teilen Hexahydrophthalsäureanhydrid, 1,5 Gew.-Teilen Dimethylbenzylamin, 220 Gew.-Teilen Quarzmehl und 80 Gew.-Teilen

Bornitridpulver wird bei 80 °C und einem Druck von 2 mbar 10 Minuten intensiv gerührt und dann in 80 °C heiße Stahlformen gegossen. Die Masse wird bei 80 °C 4 Stunden und bei 120 °C 12 Stunden ausgehärtet.

Die fertigen Formstoffe besitzen eine Wärmeleitfähigkeit von 1,28 W/mK und einen linearen Längenausdehnungskoeffizienten von $32,4 \times 10^{-6} K^{-1}$.

Beispiel 3

Zu 100 g eines nachgereinigten Epoxidharzes auf der Basis von Bisphenol A mit einer Epoxidzahl von 0,58 werden 28 g 4,4'-Diaminodiphenylmethan, 165 g Siliciumcarbid und 73 g Bornitrid bei 50 °C zugemischt. Diese Masse wird in eine Schichtdicke von 10 bis 20 mm ausgegossen. Diese geht dann bei 20 bis 25 °C im Zeitraum von 24 - 36 Stunden in den festen B-Zustand (B-stage) über.

Nach dem Granulieren wird die Masse bei 165 °C Werkzeugtemperatur und einem Druck von 70 bis 200 N/mm² verpreßt.

Die Härtezeit beträgt ca. 30 Sekunden pro mm Wandstärke des Bauteils.

Der ausgehärtete Formstoff hat eine Wärmeleitfähigkeit von 3,1 W/mK und einen Längenausdehnungskoeffizienten von $22,3 \times 10^{-6} K^{-1}$

4 Patentansprüche

0 Figuren

0157936

Patentansprüche

1. Form- und Überzugsmassen enthaltend ein Epoxidharz, einen üblichen Härter und Füllstoff neben üblichen Hilfs- und Zusatzstoffen, d a d u r c h   g e k e n n - z e i c h n e t ,   daß sie außerdem 10 bis 50 Gew.-% Bornitrid, bezogen auf die Gesamtmasse, enthalten

2. Mischung nach Anspruch 1, g e k e n n z e i c h n e t durch einen Geahlt von 20 Gew.-% Bornitrid.

3. Verwendung der Form- und Überzugsmasse nach Anspruch 1, zur Herstellung von Distanzringen  von Kathodenfallableitern.

4. Verwendung der Form- und Überzugsmasse nach Anspruch 1 zum Umhüllen von elektronischen Bauteilen.

**0157936**

Nummer der Anmeldung

Europäisches
Patentamt

# EUROPÄISCHER RECHERCHENBERICHT

## EINSCHLÄGIGE DOKUMENTE

EP 84115567.4

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | SOVIET INVENTIONS ILLUSTRATED, Sektion I Ch, Februar 1973; group 1<br><br>DERWENT PUBLICATIONS LTD.<br>London<br><br>　* SU-344 611 (GOLOVANOV et al.)<br><br>-- | 1,2,4<br><br><br><br>* | C 08 L 63/00//<br>H 01 L 23/08<br>H 01 J 1/88<br>H 01 J 29/02<br>(C 08 L 63/00<br>C 08 K 3/38) |
| X | SOVIET INVENTIONS ILLUSTRATED, Sektion El, Woche E28, 25. August 1982<br><br>DERWENT PUBLICATIONS LTD.<br>London, X12<br><br>　* SU-866 626 (DASHUK) *<br><br>-- | 1 | |
| A | EP - A2 - 0 081 329 (TOKYO SHI-BAURA DENKI K.K.)<br><br>　* Anspruch 7 *<br><br>---- | 3 | |

| RECHERCHIERTE SACHGEBIETE (Int. Cl.4) |
|---|
| C 08 L 63/00<br>H 01 L 23/00<br>H 01 J<br>C 08 K<br>H 01 T |

Der vorliegende Recherchenbericht wurde für alle Patentansprüche erstellt.

| Recherchenort | Abschlußdatum der Recherche | Prüfer |
|---|---|---|
| WIEN | 02-07-1985 | KALTENEGGER |